# EUROPEAN PATENT SPECIFICATION

(11) **EP 4 283 309 B1**
(45) Date of publication and mention of the grant of the patent: **18.02.2026**
(21) Application number: 22203345.8
(22) Date of filing: 24.10.2022
(51) Int. Cl.: G01R 3/00, G01R 1/073, B25J 9/02, B25J 9/04, B25J 15/02, B23K 26/00, B23K 1/005, B23K 3/06, B23K 3/08, B23K 101/42

(54) **TURNTABLE TYPE PROBE PIN BONDING APPARATUS WITH MULTI-AXIS GRIPPER UNIT**
SONDENSTIFTVERBINDUNGSVORRICHTUNG VOM DREHTISCHTYP MIT MEHRACHSIGER GREIFEREINHEIT
APPAREIL DE FIXATION DE BROCHE DE SONDE DE TYPE À PLATEAU TOURNANT AVEC UNITÉ DE PRÉHENSION À AXES MULTIPLES

(30) Priority: 24.05.2022 KR 20220063635
(43) Date of publication of application: 29.11.2023
(73) Proprietor: Laserssel Co., Ltd, Asan-si, Chungcheongnam-do 31499 (KR)
(72) Inventor: CHOI, Jae Joon, 12771 Gwangju-si, Gyeonggi-do (KR); KIM, Byung Roc, 21974 Incheon (KR); KIM, Tae Kyu, 18601 Hwaseong-si, Gyeonggi-do (KR); KIM, Dong Sik, 10374 Goyang-si, Gyeonggi-do (KR); LEE, Jun Gi, 31155 Goyang-si, Gyeonggi-do (KR); LEE, Sang Won, 31463 Asan-si, Chungcheongnam-do (KR)
(74) Representative: Pons IP

(56) References cited:
- KR-A- 20190 019 475
- KR-A- 20210 116 290
- US-A1- 2013 269 173
- US-A1- 2018 210 011
- MOHD ZUBIR M N ET AL: "Development of a high precision flexure-based microgripper", PRECISION ENGINEERING, ELSEVIER, AMSTERDAM, NL, vol. 33, no. 4, 1 October 2009 (2009-10-01), pages 362 - 370, XP026337725, ISSN: 0141-6359, [retrieved on 20081021], DOI: 10.1016/J.PRECISIONENG.2008.10.003

## Description

### TECHNICAL FIELD

The present invention relates to a turntable-type probe pin laser bonding apparatus wherein a pin gripper is mounted on each of the four surfaces of a pickup unit.

The laser bonding apparatus automatically laser-bonds a probe pin to a probe card while continuously rotating the pin grippers in a turntable method. More particularly, the present invention relates to a multi-axis gripper unit of a turntable type probe pin laser bonding apparatus that can continuously process the pickup, dipping, and laser bonding of probe pins while freely moving linearly and rotationally in multi-axis directions, for example, the X-axis, Y-axis, Xθ-axis, Yθ-axis, and the gripper axis, with high precision in micrometer scale.

### BACKGROUND ART

In general, a probe card is a device for testing the electrical performance of a chip formed on a semiconductor substrate.

More specifically, an innumerable plurality of probe pins is bonded to the probe card. The plurality of probe pins contacts the semiconductor chip pad and applies electrical signals to check whether the chip is normal.

As these semiconductor devices continue to be highly integrated, the circuit patterns of the semiconductor devices are also being miniaturized. Accordingly, there is also a demand for a probe card to which probe pins are bonded to have an interval corresponding to the interval of the microcircuit patterns of the semiconductor device.

However, since the conventional method of manufacturing a probe card is not fully automated, it takes a lot of time to manufacture one probe card, and the defect rate is also high.

More specifically, in the past, a person used a pincette to move and load probe pins on a wafer into a cassette. Since a person had to manually set the probe pin on the wafer vertically and then load it into the cassette, there was a problem in that the probe pin was scratched or bent, resulting in a defect.

In recent years, since the thickness of the probe pins has become finer to reduce the gap between the probe pins, the restoring force of the probe pins has been greatly reduced. That is, probe pins on the wafer are more likely to be easily damaged, even with a small impact in the process of being manually transferred to the cassette. Therefore, it is necessary to automate the transfer of the probe pin with a minimum force that does not damage the probe pin.

In addition, conventionally, when a person directly transfers a probe pin, the time for loading the probe pin on the wafer into the cassette is different depending on the technical skill level of each person. Even for a skilled person, it was difficult to accurately predict the production volume of semi-finished products over time because there was a difference in production per hour.

And conventionally, due to the thickness of the apparatus for transferring the probe pins, there was a limit in narrowing the gap between the probe pins attached to the probe card.

More specifically, since the grip module that grips and transports the probe pins on the probe card has a certain thickness, even though the thickness of the probe pins is made thin, there was a limit that the gap between the probe pins attached to the probe card could not be narrowed down to at least the thickness of the grip module.

Accordingly, at a probe card production site, there is a high demand for a probe pin bonding apparatus that can operate fully automatically, minimize the impact applied to the probe pin, and minimize the gap between the probe pins attached to the probe card.

Hereinafter, referring to FIGS. 1 and 2, the applicant of the present invention has previously filed a patent application for a turntable-type probe pin laser bonding apparatus that automatically laser bonds the probe pins to the probe card while the pin grippers mounted on each of the four sides, rotate continuously in a turntable method. This turntable-type probe pin laser bonding apparatus is disclosed in KR 2021 0116290 A, which has been filed by the applicant of the present invention.

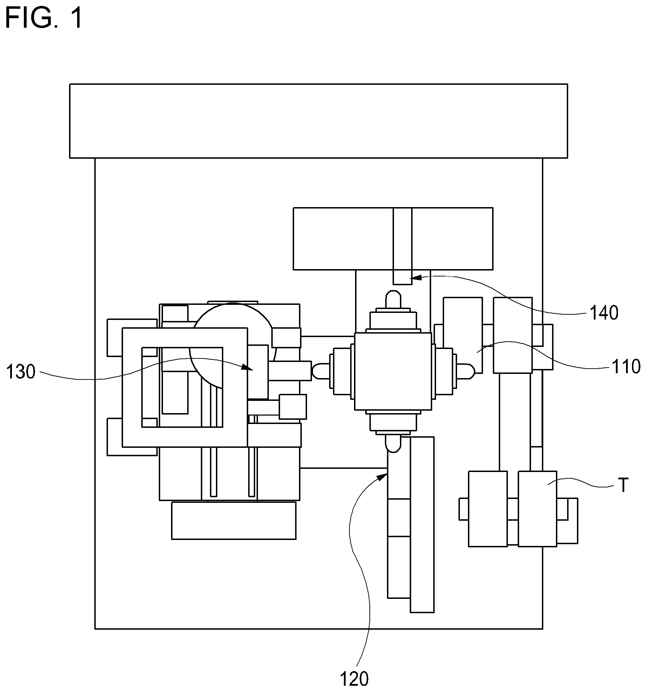

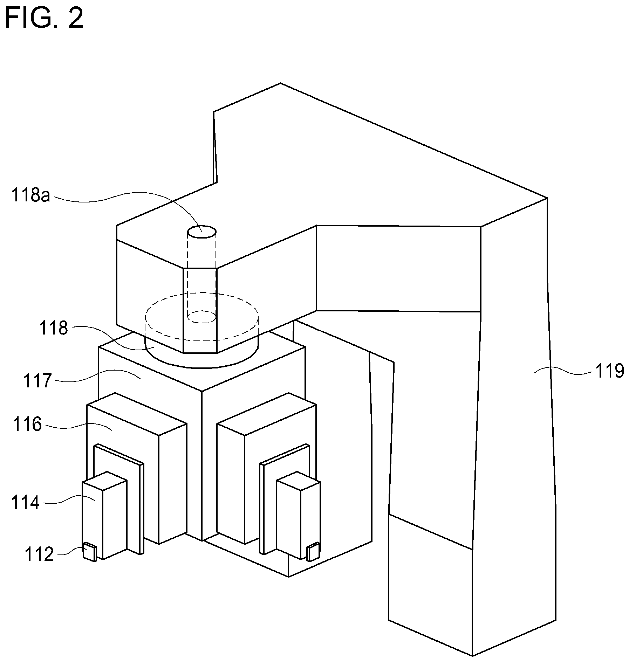

FIG. 1 is a plan view showing the configuration of a conventional turntable-type probe pin laser bonding apparatus according to some embodiments, and FIG. 2 is a perspective view separately showing the pickup unit of FIG. 1.

Referring to FIG. 1, a conventional turntable-type probe pin laser bonding apparatus (100) may include a pickup unit (110), a dipping unit (120), a laser bonding unit (130), and a suction unit (140).

First, the pickup unit (110) is located in the center of the other units (120, 130, 140) and transfers the probe pin (P) placed on the tray (T) while rotating 360 degrees around a vertical line.

As shown in FIG. 1, the pickup unit (110) may rotate in a clockwise direction with 90 degrees after picking up the probe pin (P) from the tray (T) disposed on the right side of the pickup unit (110) (based on FIG. 1).

In addition, the dipping unit (120) is located on the lower side of the pickup unit (110) (based on FIG. 1). The dipping unit (120) applies solder paste to the probe pin (P) transferred by rotating 90 degrees clockwise by the pickup unit (110).

In addition, the laser bonding unit (130) is located on the left side of the pickup unit (110) (based on FIG. 1). The laser bonding unit (130) bonds the probe pin (P) to the probe card (S) by irradiating a laser beam to the solder paste of the probe pin (P) transferred by the pickup unit (110) by being rotated 90 degrees clockwise from the dipping unit (120).

In addition, the suction unit (140) is located above the pickup unit (110) (based on FIG. 1). The suction unit (140) removes the defective probe pin (P) by suction when a defect occurs among the probe pins (P) transferred by the pickup unit (110) by being rotated 90 degrees clockwise from the laser bonding unit (130).

That is, the pickup unit (110) picks and fixes the probe pin (P) from the tray (T) while sequentially rotating clockwise by a pre-set angle (e.g., 90 degrees)for sequentially performing the dipping process by the dipping unit (120), the laser bonding process by the laser bonding unit (130), and the suction process by the suction unit (140).

Hereinafter, by referring to FIG. 2, the configuration of the pickup unit will be described in detail as follows.

A pin gripper (112) in the shape of clamps for gripping and fixing the probe pin (P) is provided at the lowest end of the pickup unit (110).

In addition, a force control unit (114) for controlling the pin gripper (112) is provided at the upper end of the pin gripper (112) so that a constant grip force is applied to the probe pin (P).

In addition, while the pin gripper (112) and the force control unit (114) are mounted on the Z-axis driving unit (116), the pin gripper (112) and the force control unit (114) are also raised and lowered together by the vertical driving of the Z-axis driving unit (116).

In addition, the Z-axis driving unit (116) is provided on each side of the body unit (117) in the shape of a square box, and the body unit (117) has four side surfaces perpendicular to each other.

Accordingly, the pin gripper (112), the force control unit (114), and the Z-axis driving unit (116) are provided on each side of the body unit (117), respectively.

In addition, a rotational driving unit (118) is integrally coupled to the upper end of the body unit (117). The body unit (117) is rotated by, for example, 90 degrees by the rotational force of the rotational driving unit (118).

When the body unit (117) rotates, the pin gripper (112), the force control unit (114), and the Z-axis driving unit (116), which are fixedly coupled to each side of the body unit (117), are also rotated together with the body unit (117).

In addition, as the support frame (119) in the form of a gantry is coupled to the upper rotation shaft (118a) of the rotational driving unit (118), the pickup unit (110) having the rotational driving unit (118) is rotatably supported by the support frame (119).

Therefore, the pickup unit (110) may pick up the probe pin (P) placed on the tray (T) and transfer it clockwise by a preset angle around the vertical line (Z-axis).

However, to continuously perform the pickup, dipping, and laser bonding processes of probe pins that are getting smaller to micrometer scale day by day, as described above, the pickup unit of the conventional probe pin laser bonding apparatus has a need for improvement such that the pin gripper moves linearly or rotationally in or around the X, Y, and Z-axis directions in micrometer scale and must be very freely and precisely transferred.

### PRIOR ARTS

1. Korean Patent No. 1748583 (Registration Date: June 16, 2017)
2. Korean Patent No. 1879376 (Registration Date: July 11, 2018)

KR 2019 0019475 A discloses a bonding gripper for a probe bonding apparatus that can reciprocated in a length (X-axis direction) direction and in a width (Y-axis direction) direction.

### DISCLOSURE OF INVENTION

### PROBLEM TO BE SOLVED BY THE INVENTION

As the present invention was invented to solve the problems described above, the present invention provides a turntable-type probe pin laser bonding apparatus according to the set of claims wherein a pin gripper may be mounted on each of the four surfaces of a pickup unit, where the laser bonding apparatus automatically laser-bonds a probe pin to a probe card while continuously rotating pin grippers in a turntable method. More particularly, the present invention relates to a multi-axis gripper unit of a turntable type probe pin laser bonding apparatus that can continuously process the pickup, dipping, and laser bonding of probe pins while freely moving linearly or rotationally in multi-axis directions, for example, the X-axis, Y-axis, Xθ-axis, Yθ-axis, and the gripper axis, with high precision in micrometer scale.

### MEANS FOR SOLVING THE PROBLEM

To achieve the above purpose, according to the present invention, it is provided a turntable-type probe pin laser bonding apparatus comprising: a pickup unit that rotates 360 degrees around an Z-axis direction, for transferring the probe pin placed on the tray after holding it with a pin gripper consisting of a pair of clamps; a dipping unit for applying solder paste to the probe pin transferred by the pickup unit; and a laser bonding unit for bonding the probe pin to a probe card by irradiating a laser beam onto the solder paste of the probe pins transferred from the dipping unit by the pickup unit, characterized in that: the pickup unit further comprises a multi-axis gripper unit and the multi-axis gripper unit comprises: an X-axis and Y-axis linear transfer module equipped at the end of the pickup unit to linearly transport (or transfer or move) the pin gripper in the X-axis and Y-axis directions; an Xθ-axis and Yθ-axis rotary transfer module equipped between the X-axis and Y-axis linear transfer module and the pin gripper to rotate the pin gripper in the Xθ-axis and Yθ-axis directions; a gripper axis linear transfer module equipped between the Xθ and Yθ axis rotary transfer module and the pin gripper to narrow or widen the gap between the clamps of the pin gripper so that the pin gripper can hold or release the probe pin.

In addition, according to some embodiments, the X-axis and Y-axis linear transfer module consists of an X-axis linear transfer module and a Y-axis linear transfer module, each of which comprises a base frame; a piezoelectric actuator disposed on the base frame in the X-axis or Y-axis direction; and a slide frame that is linearly transferred in the X-axis or Y-axis direction by the motion of the piezoelectric actuator.

In addition, according to some embodiments, the piezoelectric actuator is configured to be inserted into a tube pin member integrally coupled to the slide frame so that the tube pin member and the slide frame are linearly transferred (or moved) in the X-axis or Y-axis direction by the motion of the piezoelectric actuator.

In addition, according to some embodiments, a scale bar and an encoder PCB are further added to the slide frame and the base frame, respectively, to control the amount of linear transfer (or movement) in the X-axis or Y-axis direction.

In addition, according to some embodiments, the Xθ-axis and Yθ-axis rotary transfer module consists of an Xθ-axis rotary transfer module and a Yθ-axis rotary transfer module, each of which comprises a cover frame; a rotary block rotatably equipped within the cover frame; and a piezoelectric actuator that passes through the cover frame, for rotating the rotary block in the Xθ axis or Yθ axis direction.

In addition, according to some embodiments, the piezoelectric actuator is configured to be inserted between a pair of plate springs, which are coupled to the rotary block, so that the plate springs and the rotary block are rotationally transferred in the Xθ axis or Yθ axis direction by the motion of the piezoelectric actuator.

In addition, according to some embodiments, a scale bar and an encoder PCB are further added to the rotary block and the cover frame, respectively, to control the amount of the rotational transfer (or movement) of the rotary block in the Xθ axis or Yθ axis direction.

In addition, according to some embodiments, the gripper axis linear transfer module comprises a gripper base frame; a piezoelectric actuator fitted to the gripper base frame in the X-axis direction; a gripper slide frame that is linearly transferred (or moved) in the X-axis direction by the motion of the piezoelectric actuator.

In addition, according to some embodiments, the clamps of the pin gripper are fixed to the gripper base frame and the gripper slide frame. The gap between the clamps of the pin gripper is narrowed or widened according to the linear movement (or transfer) of the gripper slide frame in the X-axis direction.

In addition, according to some embodiments, a scale bar and an encoder PCB are further added to the gripper slide frame and the gripper base frame, respectively, to control the amount of linear transfer (or movement) of the gripper slide frame in the X-axis direction.

### EFFECT OF THE INVENTION

As described above, in the present invention, the multi-axis gripper unit added to the turntable-type probe pin laser bonding apparatus freely moves linearly or rotationally in the multi-axis direction, for example, in the X-axis, Y-axis, Xθ-axis, Yθ-axis, and the gripper X-axis direction with high precision in micrometer scale.-It enables the turntable-type probe pin laser bonding apparatus to perform pickup, dipping, and laser bonding of probe pins. Accordingly, the efficiency and precision of the probe pin bonding process are greatly improved.

Accordingly, it is possible to prepare for the laser bonding process of the probe pin, which is being refined day by day to a micrometer scale. Also, the physical damage applied to very fine and sophisticated probe pins during continuous processes such as pickup, dipping, and laser bonding of the probe pins.

### BRIEF DESCRIPTION OF DRAWINGS

FIG. 1 is a plan view showing the configuration of a conventional turntable-type probe pin laser bonding apparatus.
FIG. 2 is a perspective view showing the pickup unit of FIG. 1, separately from the turntable-type probe pin laser bonding apparatus.
FIG. 3 is a full perspective view of the multi-axis gripper unit of the turntable-type probe pin laser bonding apparatus according to some embodiments of the present invention.
FIG. 4 is an exploded perspective view showing the X-axis and Y-axis linear transfer module of FiG. 3.
FIG. 5 is an exploded perspective view showing the Yθ axis rotary transfer module of FIG. 3.
FIG. 6 is an exploded perspective view showing the Xθ axis rotary transfer module of FIG. 3.
FIG. 7 is an exploded perspective view showing the gripper axis linear transfer module of FIG. 3.

### MODE(S) FOR CARRYING OUT THE INVENTION

The terminology herein describes particular embodiments only and is not intended to be limiting. As used herein, the singular forms "a," "an," and "the" are intended to include the plural forms, including "at least one," unless the content clearly indicates otherwise. It will be further understood that the terms "comprises," "comprising," "includes," and/or "including," when used in this specification, specify the presence of stated features, integers, steps, operations, elements, and/or components, but do not preclude the presence or addition of one or more other features, integers, steps, operations, elements, components, and/or groups thereof.

Unless otherwise defined in this specification, all terms used herein (including technical and scientific terms) have the same meaning as commonly understood by those skilled in the art.

It will be further understood that terms, such as those defined in commonly used dictionaries, should be interpreted as having a meaning that is consistent with their meaning in the context of the relevant art and will not be interpreted in an ideal or excessively formal sense unless clearly defined in the present specification.

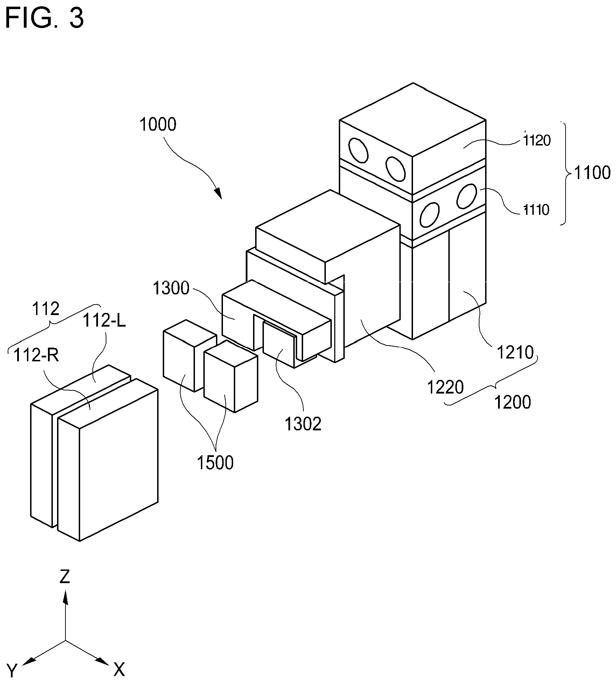

Hereinafter, the multi-axis gripper unit of the turntable-type probe pin laser bonding apparatus, according to some embodiments of the present invention, will be described in detail with reference to the accompanying drawings of FIGS. 3 to 7 as follows.

As described above with reference to FIGS. 1 and 2, the turntable-type probe pin laser bonding apparatus of the present invention comprises: a pickup unit that rotates 360 degrees around the Z-axis and transfers the probe pin placed on the tray after holding it with a pin gripper consisting of a pair of clamps; a dipping unit applies solder paste to the probe pin transferred by the pickup unit; and a laser bonding unit that bonds the probe pins to a probe card by irradiating a laser beam onto the solder paste of the probe pins transferred from the dipping unit by the pickup unit.

FIG. 3 is a full perspective view of the multi-axis gripper unit (1000) for a turntable-type probe pin laser bonding apparatus according to some embodiments of the present invention.

Referring to FIG. 3, the multi-axis gripper unit is configured as a 5-axis module according to the present invention.

First, as the first and second components of the 5-axis module, an X-axis and Y-axis linear transfer module (1100: 1110, 1120) for linearly transporting (or transferring or moving) the pin gripper (112) in the X-axis or Y-axis direction is provided at the end of the pickup unit (110) of the turntable-type probe pin laser bonding apparatus. In FIG. 3, the X-axis and Y-axis linear transfer module (1100) is formed by a combination of a Y-axis linear transfer module (1120) and an X-axis linear transfer module (1110).

In addition, as the third and fourth components of the 5-axis module, an Xθ-axis and Yθ-axis rotary transfer module (1200: 1210, 1220 for rotating the pin gripper (112) in the Xθ-axis or Yθ-axis direction is provided between the X-axis and Y-axis linear transfer module (1100) and the pin gripper (112). Referring to FIG. 3, the Xθ-axis and Yθ-axis rotary transfer module (1200) is formed by a combination of a Yθ-axis rotary transfer module (1210) and an Xθ-axis rotary transfer module (1220).

In addition, as the fifth component of the 5-axis module, a gripper axis linear transfer module (1300) for narrowing or widening the gap between the clamps of the pin gripper (112) is provided so that the pin gripper (112) can hold or release a probe pin (not shown). The gripper axis linear transfer module (1300) is provided between the Xθ axis and Yθ axis rotary transfer module (1200) and the pin gripper (112).

In addition, as shown in FIG. 3, a separate bracket (1500) may be further provided for screwing and fixing the pin gripper (112) to the gripper axis linear transfer module (1300)

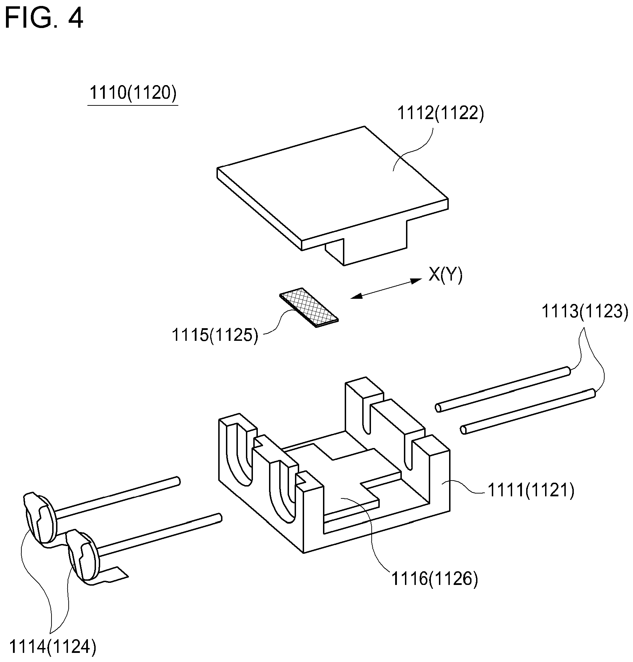

FIG. 4 is an exploded perspective view showing the main part in an enlarged view of the X-axis and Y-axis linear transfer module of FiG. 3.

Referring to FIG. 4, the X-axis-linear transfer module (1110) comprises a ' 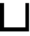 ' shaped base frame (1111), a pair of piezoelectric actuators (1114) positioned on the base frame (1111) in the X-axis direction, and a slide frame (1112) that is configured to be linearly transported or moved in the X-axis direction by a motion, such as vibration, of the piezoelectric actuators (1114). Similary, the Y-axis linear transfer module (1120) may comprise a 'U' shaped base frame (1121), a pair of piezoelectric actuators (1124) disposed on the base frame (1121) in the Y-axis directioin, and a slide frame (1122) configured to be linearly transported or moved in the Y-axis direction by a motion of the piezoelectric actuators (1124).

The piezoelectric actuator may be, for example, a miniature piezoelectric actuator using a piezoelectric ceramic. The miniature piezoelectric actuator applies an electric field to the piezoelectric ceramic polarized in one direction so that a contraction or expansion motion occurs in the piezoelectric ceramic according to the direction of polarization and the direction of the applied electric field

In addition, the piezoelectric actuators (1114)(1124) are configured to be inserted into the tube pin members (1113)(1123) integrally coupled to the slide frames (1112)(1122). As electric energy is applied to the piezoelectric actuators (1112)(1122), a fine motion such as vibration is generated. By the motion of the piezoelectric actuators (1112)(1122), the tube pin members (1113)(1123) and the slide frames (1112)(1122) are linearly transported very precisely in the X-axis or Y-axis direction.

In addition, as a scale bar (1115)(1125) and an encoder PCB (1116)(1126) are further added to the slide frames (1112)(1122) and the base frames (1111)(1121), respectively, the amount of linear movement (or transfer or transport) in the X-axis or Y-axis direction of the slide frame (1112)(1122) is precisely controlled.

Accordingly, by the combination of the piezoelectric actuators (1114)(1124), the scale bars (1115)(1125), and the encoder PCBs (1116)(1126), the X-axis and Y-axis linear transfer modules (1110)(1120) can linearly transport the slide frames (1112)(1122) very precisely in micrometer scale.

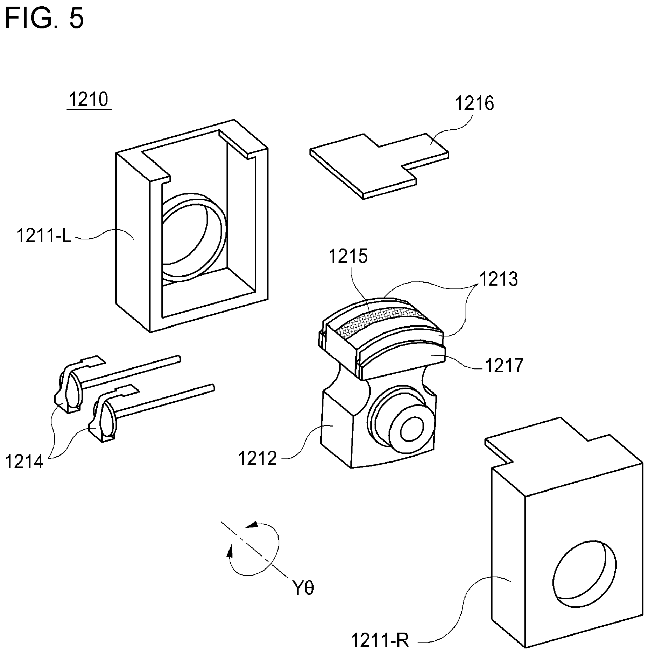

FIG. 5 is an exploded perspective view showing the main part in an enlarged view of the Yθ axis rotary transfer module of FIG. 3.

Referring to FIG. 5, the Yθ axis rotary transfer module (1210) comprises a cover frame (1211) consisting of a pair of (i.e., left and right) cover frames (1211-L, 1211-R), a rotary block (1212) rotatably equipped within the pair of cover frames (1211-L, 1211-R), a piezoelectric actuator (1214) that passes through the cover frame (1211) for rotating the rotary block (1212) in the Yθ axis direction in a coupled state.

As shown in FIG. 5, the rotary block (1212) is formed as a rotating body having a circular arc-shaped curved surface and a rotation shaft, and a pair of plate springs (1213) is coupled to the left and right sides of the round curved surface, respectively.

At this time, the plate springs (1213) are fixedly coupled to the rotary block (1212) in a state of being spaced apart from each other by a predetermined interval by at least one or more spacers (1217).

Subsequently, as the piezoelectric actuator (1214) is positioned in a state to be inserted between the pair of plate springs (1213), the plate springs (1213) and the rotary block (1212) are precisely rotationally transferred (or transported or moved) in the Yθ axis direction by minute motions such as vibration of the piezoelectric actuator (1214).

In addition, a scale bar (1215) and an encoder PCB (1216) are further added to the rotary block (1212) and the cover frame (1211), respectively, so that the amount of rotational movement (or transfer) of the rotary block (1212) in the Yθ-axis direction-is precisely controlled.

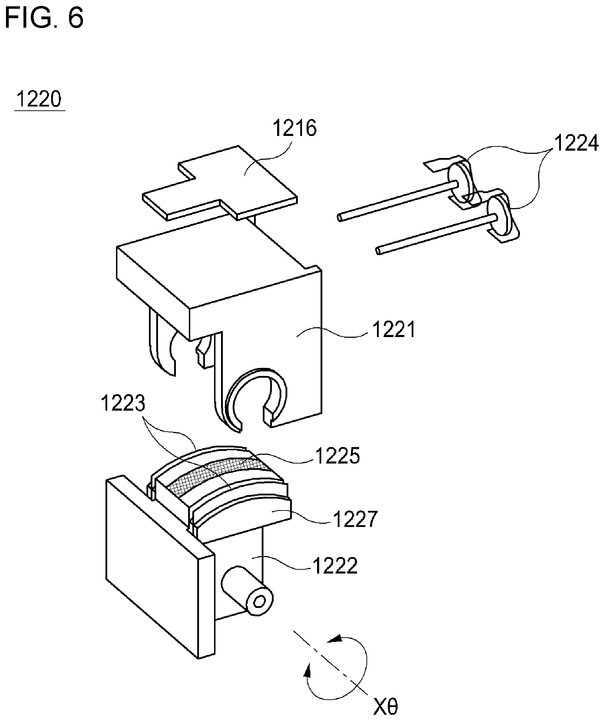

FIG. 6 is an exploded perspective view showing the main part in an enlarged Xθ axis rotary transfer module of FIG. 3.

FIG. 6 shows an embodiment of an Xθ-axis rotary transfer module. Unlike the configuration of the cover frame (1211) of the Yθ-axis rotary transfer module (1210) in FIG. 5, the cover frame (1221) of the Xθ-axis rotary transfer module (1220) of FIG. 6 may be integrally formed as one piece. The remaining components (1222, 1223, 1224, 1225, 1226, and 1227) may be configured in the same manner as the configuration of the corresponding components in FIG. 5. Hereinafter, a description of the same configuration as that of FIG. 5 will be omitted.

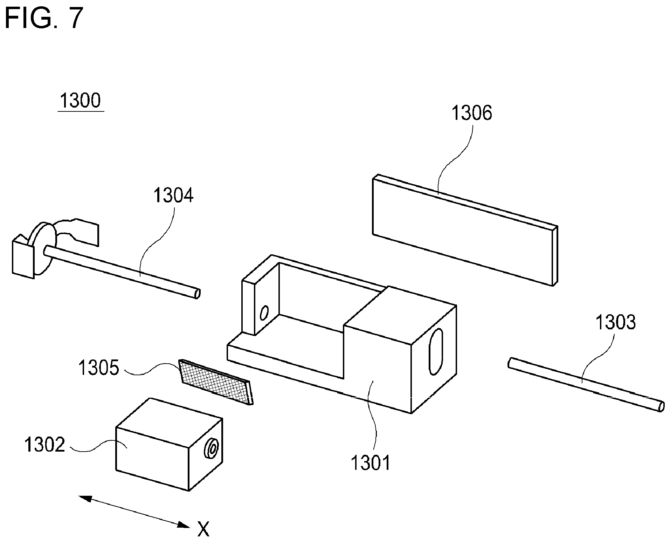

FIG. 7 is an exploded perspective view showing the main part of an enlarged gripper axis linear transfer module of FIG. 3.

Referring to FIG. 7, the gripper axis linear transfer module (1300) comprises a gripper base frame (1301), a piezoelectric actuator (1303) fitted to the gripper base frame (1301) in the X-axis direction, and a gripper slide frame (1302) that is linearly transported (or transferred or moved) in the X-axis direction by the motion of the piezoelectric actuator (1303).

The piezoelectric actuator (1304) is configured to be inserted into a tube pin member (1303) coupled to the gripper slide frame (1302). When a minute motion such as vibration is generated in the piezoelectric actuator (1304), the tube pin member (1303) and the gripper slide frame (1302) are precisely linearly transferred (or transported or moved) in the X-axis direction on a micrometer scale.

Referring to both FIG. 3 and FIG. 7, the left and right clamps (112-L, 112-R) of the pin gripper (112) are fixed to the gripper base frame (1301) and the gripper slide frame (1302), respectively. By the motion of the piezoelectric actuator (1304), the gap between the left and right clamps (112-L, 112-R) of the pin gripper (112) is operated to narrow or widen so that the pin gripper (112) can hold or release a probe pin (not shown) according to the linear movement (or transfer) of the gripper slide frame (1302) in the X-axis direction.

In addition, a scale bar (1305) and an encoder PCB (1306) are further added to the gripper slide frame (1302) and the gripper base frame (1301), respectively, so that the amount of linear transfer (or movement) of the gripper slide frame (1302) in the X-axis direction can be precisely controlled.

### DESCRIPTION OF THE NUMERALS

[0084] 112 (112-L, 112-R): pin gripper (left. Right clamps)
1000: (the present invention) multi-axis gripper unit
1100: an X-axis and Y-axis linear transfer module
1110: X-axis linear transfer module
1120: Y-axis linear transfer module
1111, 1121: base frame
1112, 1122: slide frame
1113, 1123: tube pin member
1114, 1124: piezoelectric actuator
1115, 1125: scale bar
1116, 1126: encoder PCB
1200: Xθ-axis and Yθ-axis rotary transfer module
1210: Yθ-axis rotary transfer module
1220: Xθ-axis rotary transfer module
1211: cover frame
1212, 1222: rotary block
1213, 1223: plate spring
1214, 1224: piezoelectric actuator
1215, 1225: scale bar
1216, 1226: encoder PCB
1217, 1227: spacer
1300: gripper axis linear transfer module
1301: gripper base frame
1302: gripper slide frame
1303: tube pin member
1304: piezoelectric actuator
1305: scale bar
1306: encoder PCB

## Claims

1. A turntable-type probe pin laser bonding apparatus comprising:
a pickup unit (110) that rotates 360 degrees around an Z-axis direction, for transferring the probe pin placed on the tray after holding it with a pin gripper (112) consisting of a pair of clamps;
a dipping unit (120) for applying solder paste to the probe pin transferred by the pickup unit; and
a laser bonding unit (130) for bonding the probe pin to a probe card by irradiating a laser beam onto the solder paste of the probe pins transferred from the dipping unit by the pickup unit, **characterized in that**: the pickup unit comprises a multi-axis gripper unit (1000) comprising:
an X-axis and Y-axis linear transfer module (1100) equipped at the end of the pickup unit to linearly transfer the pin gripper (112) in the X-axis and Y-axis directions;
an Xθ-axis and Yθ-axis rotary transfer module (1200) equipped between the X-axis and Y-axis linear transfer module (1100) and the pin gripper (112) to rotate the pin gripper in the Xθ-axis and Y-axis directions; and
a gripper axis linear transfer module (1300) equipped between the Xθ-axis and Yθ-axis rotary transfer module (1200) and the pin gripper (112) to narrow or widen the gap between the clamps of the pin gripper so that the pin gripper can hold or release the probe pin.

2. The turntable-type probe pin laser bonding apparatus of claim 1,
wherein the X-axis and Y-axis linear transfer module-(1100) consists of an X-axis linear transfer module (1110) and a Y-axis linear transfer module (1120), each of which comprising:
a base frame (1111)(1121);
a piezoelectric actuator (1114)(1124) disposed on the base frame in the X-axis or Y-axis direction; and
a slide frame (1112)(1122) that is linearly transferred in the X-axis or Y-axis direction by the motion of the piezoelectric actuator.

3. The turntable-type probe pin laser bonding apparatus of claim 2,
wherein the piezoelectric actuator (1114)(1124) is configured to be inserted into a tube pin member (1113)(1123), which is integrally coupled to the slide frame (1112)(1122), so that the tube pin member and the slide frame are linearly transferred in the X-axis or Y-axis direction by the motion of the piezoelectric actuator.

4. The turntable-type probe pin laser bonding apparatus of claim 2,
wherein a scale bar (1115)(1125) and an encoder PCB (1116)(1126) are further added to the slide frame (1112)(1122) and the base frame (1111)(1121), respectively, to control the linear transfer amount of the slide frame in the X-axis or Y-axis direction.

5. The turntable-type probe pin laser bonding apparatus of claim 1,
wherein the Xθ-axis and Yθ-axis rotary transfer module-(1200) consists of an Xθ-axis rotary transfer module (1220) and a Yθ-axis rotary transfer module (1210), each of which comprising:
a cover frame (1211)(1221);
a rotary block (1212)(1222) rotatably equipped within the cover frames; and
a piezoelectric actuator (1214)(1224) that passes through the cover frame, for rotating the rotary block in the Xθ-axis or Yθ--axis direction.

6. The turntable-type probe pin laser bonding apparatus of claim 5,
wherein the piezoelectric actuator (1214)(1224) is configured to be inserted between a pair of plate springs (1213)(1223), which are coupled to the rotary block (1212)(1222), so that the plate springs and the rotary block are rotationally transferred in the Xθ--axis or Yθ-axis direction by the motion of the piezoelectric actuator.

7. The turntable-type probe pin laser bonding apparatus of claim 5,
wherein a scale bar (1215)(1225) and an encoder PCB (1216)(1226) are further added to the rotary block (1212)(1222) and the cover frame (1211)(1221), respectively, to control the rotational transfer amount of the rotary block in the Xθ-axis or Yθ-axis direction.

8. The turntable-type probe pin laser bonding apparatus of claim 1,
wherein the gripper axis linear transfer module (1300) comprises;
a gripper base frame (1301);
a piezoelectric actuator (1304) fitted to the gripper base frame in the X-axis direction; and
a gripper slide frame (1302) that is linearly transferred in the X-axis direction by the motion of the piezoelectric actuator.

9. The turntable-type probe pin laser bonding apparatus of claim 8,
wherein the clamps of the pin gripper (112) are fixed to the gripper base frame (1301) and the gripper slide frame (1302), respectively, and the gap between the clamps of the pin gripper is narrowed or widened according to the linear movement of the gripper slide frame in the X-axis direction.

10. The turntable-type probe pin laser bonding apparatus of claim 8,
wherein a scale bar (1305) and an encoder PCB (1306) are further added to the gripper slide frame (1302) and the gripper base frame (1301), respectively, to control the linear transfer amount of the gripper slide frame in the X-axis direction.

## Patentansprüche

1. Sondenstiftlaserverbindungsvorrichtung vom Drehtischtyp, umfassend:
eine Aufnahmeeinheit (110), die 360 Grad um eine Z-Achsenrichtung rotiert, um den auf der Ablage platzierten Sondenstift zu transferieren, nachdem er mit einem aus einem Paar Klemmen bestehenden Stiftgreifer (112) gehalten wurde;
eine Eintaucheinheit (120) zum Auftragen von Lötpaste auf den von der Aufnahmeeinheit transferierten Sondenstift; und
eine Laserverbindungseinheit (130) zum Verbinden des Sondenstifts mit einer Sondenkarte durch Einstrahlen eines Laserstrahls auf die Lötpaste der Sondenstifte, die von der Eintaucheinheit durch die Aufnahmeeinheit transferiert werden, **dadurch gekennzeichnet, dass** die Aufnahmeeinheit eine mehrachsige Greifereinheit (1000) umfasst, die Folgendes umfasst:
ein X-Achsen- und Y-Achsen-Lineartransfermodul (1100), das am Ende der Aufnahmeeinheit vorgesehen ist, um den Stiftgreifer (112) in den X-Achsen- und Y-Achsenrichtungen linear zu transferieren;
ein Xθ-Achsen- und Yθ-Achsen-Rotationstransfermodul (1200), das zwischen dem X-Achsen- und Y-Achsen-Lineartransfermodul (1100) und dem Stiftgreifer (112) vorgesehen ist, um den Stiftgreifer in der Xθ-Achsen- und Yθ-Achsenrichtung zu drehen; und
ein Greiferachsen-Lineartransfermodul (1300), das zwischen dem Xθ-Achsen- und Yθ-Achsen-Rotationstransfermodul (1200) und dem Stiftgreifer (112) vorgesehen ist, um den Spalt zwischen den Klemmen des Stiftgreifers zu verengen oder zu erweitern, so dass der Stiftgreifer den Sondenstift halten oder freigeben kann.

2. Sondenstiftlaserverbindungsvorrichtung vom Drehtischtyp nach Anspruch 1,
wobei das X-Achsen- und Y-Achsen-Lineartransfermodul (1100) aus einem X-Achsen-Lineartransfermodul (1110) und einem Y-Achsen-Lineartransfermodul (1120) besteht, von denen jedes
Folgendes umfasst:
einen Grundrahmen (1111)(1121);
einen piezoelektrischen Aktuator (1114)(1124), der auf dem Grundrahmen in der X-Achsen- oder Y-Achsenrichtung angeordnet ist; und
einen Gleitrahmen (1112)(1122), der durch die Bewegung des piezoelektrischen Aktuators linear in der X-Achsen- oder Y-Achsenrichtung transferiert wird.

3. Sondenstiftlaserverbindungsvorrichtung vom Drehtischtyp nach Anspruch 2,
wobei der piezoelektrische Aktuator (1114)(1124) dazu konfiguriert ist, in ein Rohrstiftelement (1113)(1123) eingefügt zu werden, das einstückig mit dem Gleitrahmen (1112)(1122) gekoppelt ist, so dass das Rohrstiftelement und der Gleitrahmen durch die Bewegung des piezoelektrischen Aktuators linear in der X-Achsen- oder Y-Achsenrichtung transferiert werden.

4. Sondenstiftlaserverbindungsvorrichtung vom Drehtischtyp nach Anspruch 2,
wobei eine Skalenleiste (1115)(1125) und eine Encoder-Leiterplatte (1116)(1126) weiter jeweils zu dem Gleitrahmen (1112)(1122) und dem Grundrahmen (1111)(1121) hinzugefügt werden, um den Betrag des linearen Transfers des Gleitrahmens in der X-Achsen- oder Y-Achsenrichtung zu steuern.

5. Sondenstiftlaserverbindungsvorrichtung vom Drehtischtyp nach Anspruch 1,
wobei das Xθ-Achsen- und Yθ-Achsen-Rotationstransfermodul (1200) aus einem Xθ-Achsen-Rotationstransfermodul (1220) und einem Yθ-Achsen-Rotationstransfermodul (1210) besteht, von denen jedes Folgendes umfasst:
einen Abdeckrahmen (1211)(1221);
einen Rotationsblock (1212)(1222), der rotierbar innerhalb der Abdeckrahmen vorgesehen ist; und
einen piezoelektrischen Aktuator (1214)(1224), der durch den Abdeckrahmen verläuft, um den Rotationsblock in der Xθ-Achsen- oder Yθ-Achsenrichtung zu rotieren.

6. Sondenstiftlaserverbindungsvorrichtung vom Drehtischtyp nach Anspruch 5,
wobei der piezoelektrische Aktuator (1214)(1224) dazu konfiguriert ist, zwischen ein Paar Tellerfedern (1213)(1223) eingefügt zu werden, die mit dem Rotationsblock (1212)(1222) gekoppelt sind, so dass die Tellerfedern und der Rotationsblock durch die Bewegung des piezoelektrischen Aktuators in der Xθ-Achsen- oder Yθ-Achsenrichtung rotatorisch transferiert werden.

7. Sondenstiftlaserverbindungsvorrichtung vom Drehtischtyp nach Anspruch 5,
wobei eine Skalenleiste (1215)(1225) und eine Encoder-Leiterplatte (1216)(1226) weiter jeweils zu dem Rotationsblock (1212)(1222) und dem Abdeckrahmen (1211)(1221) hinzugefügt werden, um den Betrag des Rotationstransfers des Rotationsblocks in der Xθ-Achsen- oder Yθ-Achsenrichtung zu steuern.

8. Sondenstiftlaserverbindungsvorrichtung vom Drehtischtyp nach Anspruch 1,
wobei das Greiferachsen-Lineartransfermodul (1300) Folgendes umfasst:
einen Greifergrundrahmen (1301);
einen piezoelektrischen Aktuator (1304), der an dem Greifergrundrahmen in der X-Achsenrichtung angebracht ist; und
einen Greifergleitrahmen (1302), der durch die Bewegung des piezoelektrischen Aktuators linear in der X-Achsenrichtung transferiert wird.

9. Sondenstiftlaserverbindungsvorrichtung vom Drehtischtyp nach Anspruch 8,
wobei die Klemmen des Stiftgreifers (112) jeweils am Greifergrundrahmen (1301) und am Greifergleitrahmen (1302) fixiert sind und der Spalt zwischen den Klemmen des Stiftgreifers gemäß der linearen Bewegung des Greifergleitrahmens in Richtung der X-Achse verengt oder erweitert wird.

10. Sondenstiftlaserverbindungsvorrichtung vom Drehtischtyp nach Anspruch 8,
wobei eine Skalenleiste (1305) und eine Encoder-Leiterplatte (1306) weiter jeweils zu dem Greifergleitrahmen (1302) und dem Greifergrundrahmen (1301) hinzugefügt werden, um den Betrag des Lineartransfers des Greifergleitrahmens in der X-Achsenrichtung zu steuern.

## Revendications

1. Appareil de liaison laser de broches de sonde de type plateau tournant comprenant :
une unité de saisie (110) qui entre en rotation à 360 degrés autour de l'axe Z, pour le transfert de la broche de sonde placée sur le plateau après l'avoir maintenue avec une pince de broche (112) constituée d'une paire de mors ;
une unité de trempage (120) pour l'application de la pâte à braser sur la broche de sonde transférée par l'unité de saisie ; et
une unité de liaison laser (130) pour la liaison de la broche de sonde à une carte de sonde en irradiant un faisceau laser sur la pâte à braser des broches de sonde transférées depuis l'unité de trempage par l'unité de saisie, **caractérisé en ce que** : l'unité de saisie comprend une unité de pince multiaxiale (1000) comprenant :
un module de transfert linéaire d'axe X et d'axe Y (1100) équipé au niveau de l'extrémité de l'unité de saisie pour transférer linéairement la pince de broche (112) dans les directions de l'axe X et de l'axe Y ;
un module de transfert rotatif d'axe Xθ et d'axe Yθ (1200) équipé entre le module de transfert linéaire d'axe X et d'axe Y (1100) et la pince de broche (112) pour mettre en rotation la pince de broche dans les directions de l'axe Xθ et de l'axe Yθ ; et
un module de transfert linéaire d'axe de pince (1300) équipé entre le module de transfert rotatif d'axe Xθ et d'axe Yθ (1200) et la pince de broche (112) pour réduire ou élargir l'écart entre les mors de la pince de broche de sorte que la pince de broche puisse maintenir ou libérer la broche de sonde.

2. Appareil de liaison laser de broches de sonde de type plateau tournant selon la revendication 1,
dans lequel le module de transfert linéaire d'axe X et d'axe Y (1100) est constitué d'un module de transfert linéaire d'axe X (1110) et d'un module de transfert linéaire d'axe Y (1120), chacun d'entre eux
comprenant :
un carter de base (1111)(1121) ;
un actionneur piézoélectrique (1114) (1124) disposé sur le carter de base dans la direction de l'axe X ou de l'axe Y ; et
un carter coulissant (1112)(1122) qui est transféré linéairement dans la direction de l'axe X ou de l'axe Y par le mouvement de l'actionneur piézoélectrique.

3. Appareil de liaison laser de broches de sonde de type plateau tournant selon la revendication 2,
dans lequel l'actionneur piézoélectrique (1114)(1124) est configuré pour être inséré dans un élément de broche tubulaire (1113)(1123), qui est intégralement accouplé au carter coulissant (1112)(1122), de sorte que l'élément de broche tubulaire et le carter coulissant sont transférés linéairement dans la direction de l'axe X ou de l'axe Y par le mouvement de l'actionneur piézoélectrique.

4. Appareil de liaison laser de broches de sonde de type plateau tournant selon la revendication 2,
dans lequel une échelle graphique (1115)(1125) et une carte de circuit imprimé d'encodeur (1116)(1126) sont en outre ajoutés au carter coulissant (1112)(1122) et au carter de base (1111)(1121), respectivement, pour contrôler la quantité de transfert linéaire du carter coulissant dans la direction de l'axe X ou de l'axe Y.

5. Appareil de liaison laser de broches de sonde de type plateau tournant selon la revendication 1,
dans lequel le module de transfert rotatif d'axe Xθ et d'axe Yθ (1200) est constitué d'un module de transfert rotatif d'axe Xθ (1220) et d'un module de transfert rotatif d'axe Yθ (1210), chacun d'entre eux comprenant :
un carter de protection (1211 )(1221) ;
un bloc rotatif (1212) (1222) équipé de manière rotative à l'intérieur des carters de protection ; et
un actionneur piézoélectrique (1214)(1224) qui traverse le carter d'enveloppe, pour la rotation du bloc rotatif dans la direction de l'axe Xθ ou de l'axe Yθ.

6. Appareil de liaison laser de broches de sonde de type plateau tournant selon la revendication 5,
dans lequel l'actionneur piézoélectrique (1214)(1224) est configuré pour être inséré entre une paire de ressorts plats (1213)(1223), qui sont accouplés au bloc rotatif (1212)(1222), de sorte que les ressorts plats et le bloc rotatif soient transférés de manière rotationnelle dans la direction de l'axe Xθ ou de l'axe Yθ par le mouvement de l'actionneur piézoélectrique.

7. Appareil de liaison laser de broches de sonde de type plateau tournant selon la revendication 5,
dans lequel une échelle graphique (1215)(1225) et une carte de circuit imprimé d'encodeur (1216)(1226) sont en outre ajoutés au bloc rotatif (1212)(1222) et au carter de protection (1211)(1221), respectivement, pour contrôler la quantité de transfert rotationnel du bloc rotatif dans la direction de l'axe Xθ ou de l'axe Yθ.

8. Appareil de liaison laser de broches de sonde de type plateau tournant selon la revendication 1,
dans lequel le module de transfert linéaire d'axe de pince (1300) comprend :
un carter de base de pince (1301) ;
un actionneur piézoélectrique (1304) monté sur le carter de base de pince dans la direction de l'axe X ; et
un carter coulissant de pince (1302) qui est transféré linéairement dans la direction de l'axe X par le mouvement de l'actionneur piézoélectrique.

9. Appareil de liaison laser de broches de sonde de type plateau tournant selon la revendication 8,
dans lequel les mors de la pince de broche (112) sont fixés au carter de base de pince (1301) et au carter coulissant de pince (1302), respectivement, et l'espace entre les mors de la pince est réduit ou élargi en fonction du mouvement linéaire du carter coulissant de pince dans la direction de l'axe X.

10. Appareil de liaison laser de broches de sonde de type plateau tournant selon la revendication 8,
dans lequel une échelle graphique (1305) et une carte de circuit imprimé d'encodeur (1306) sont en outre ajoutées au carter coulissant de pince (1302) et au carter de base de coulisseau-pince (1301), respectivement, pour contrôler la quantité de transfert linéaire du carter coulissant de pince dans la direction de l'axe X.
